# EUROPEAN PATENT SPECIFICATION

(11) **EP 3 731 616 B1**
(45) Date of publication and mention of the grant of the patent: **31.07.2024**
(21) Application number: 17935787.6
(22) Date of filing: 21.12.2017
(51) Int. Cl.: H05K 13/02, H05K 13/04

(54) **TAPE FEEDER**
BANDZUFÜHRER
DISPOSITIF D'ALIMENTATION EN BANDE

(43) Date of publication of application: 28.10.2020
(73) Proprietor: Fuji Corporation, Chiryu-shi, Aichi 472-8686 (JP)
(72) Inventor: SAKURAYAMA Takeshi, Chiryu-shi, Aichi 472-8686 (JP); SUZUKI Daiki, Chiryu-shi, Aichi 472-8686 (JP)
(74) Representative: Grünecker Patent- und Rechtsanwälte PartG mbB
(86) International application number: PCT/JP2017/046031
(87) International publication number: WO 2019/123621

(56) References cited:
- JP-A- 2017 076 688
- JP-A- H0 228 999
- JP-A- H0 823 190
- KR-A- 20090 100 935
- US-A- 6 139 246

## Description

### Technical Field

The present disclosure relates to a tape feeder for supplying electronic components to an electronic component mounting machine.

### Background Art

A tape feeder is provided with a conveyance path for feeding tape containing electronic components. The tape is conveyed through the conveyance path by the sprockets. At the downstream end of the conveyance path, the extraction position of the electronic component is set. A suction nozzle of the electronic component mounting machine conveys the electronic component from the extraction position to a predetermined coordinate on a board. When the tape is deviated in the path width direction, with respect to the extraction position, the actual position of the electronic component may be deviated in the path width direction. Therefore, the suction position of a suction nozzle with respect to the electronic component is deviated. Therefore, such a deviation lowers the positional accuracy of the electronic component with respect to the board.

In this regard, Patent Literature 1 discloses an electronic component supply device including a tape holding member. The tape holding member has a leaf spring shape. The tape holding member is in elastic contact with the side face of the tape in the path width direction. The tape is offset in the path width direction by the tape holding member. Therefore, according to the electronic component supply device of Patent Literature 1, it is possible to suppress the deviation of the tape in the path width direction. Patent Literature 2 discloses a tape guide with a tape holding member that locally comprises an elastic tab that presses the side of the tape to the opposite side of the tape guide. Patent Literature 3 discloses a tape guide with a width control unit for adapting the width of the tape guide to the width of a tape to be fed. The carrier tape guiding assembly of Patent Literature 4 comprises at least two spring loaded wire guides for biasing the carrier tape towards a side rail and providing flexibility to accommodate different carrier tape widths.

### Patent Literature

Patent Literature 1: JP-A-2000-40897
Patent Literature 2: JP H02 28999 A
Patent Literature 3: KR 2009 0100935 A
Patent Literature 4: US 6 139 246 A

### Summary of the Invention

### Technical Problem

However, according to the electronic component supply device of Patent Literature 1, the conveyance path of the tape is entirely offset in the path width direction. In this regard, the path width of the conveyance path itself is invariant over the entire length of the conveyance path. Here, an object of the present disclosure is to provide a tape feeder capable of partially adjusting a path width of a conveyance path.

### Solution to Problem

In order to solve the above problems, according to the present disclosure, there is provided a tape feeder including: a feeder main body including a conveyance path through which a tape having electronic components accommodated therein in multiple component accommodation sections is conveyed and which has a base width section wider than the tape and a narrow width section narrower than the base width section, the base width section being provided at another part of the conveyance path than the narrow width section; and a width regulating section that abuts against the tape conveyed through the conveyance path from a path width direction of the conveyance path so as to set the narrow width section on the conveyance path, wherein the conveyance path has an extraction position at which the electronic component is extracted from the tape, the multiple component accommodation sections are provided at an interval C in the conveyance direction, and the width regulating section is disposed in the vicinity of the extraction position within an interval between two times C in the down-stream direction of the extraction position and four times C in the up-stream direction of the extraction position. Here, the "path width direction" means a direction intersecting with the extending direction of the conveyance path.

### Advantageous Effect of the Invention

The conveyance path of the tape feeder has the base width section and the narrow width section. The base width section is wider than the tape. Therefore, the tape can be smoothly conveyed. The narrow width section is narrower than the base width section. Therefore, it is possible to suppress the deviation of the tape in the path width direction.

### Brief Description of Drawings

Fig. 1 is a top view of a tape feeder according to one embodiment of the present disclosure.
Fig. 2 is a transmission right view of the tape feeder.
Fig. 3 is an enlarged view of a frame III of Fig. 1.
Fig. 4 is a perspective view of the frame III.
Fig. 5 is an exploded perspective view of the frame III.
Fig. 6 is a top view of the vicinity of a width regulating block of the tape feeder according to another (first) embodiment.
Fig. 7 is a top view of the vicinity of the width regulating block of the tape feeder according to another (second) embodiment.
Fig. 8 is a top view of the tape feeder according to another (third) embodiment, in the vicinity of the width regulating block when the tape having a wide width is conveyed.
Fig. 9 is a top view of the tape feeder in the vicinity of the width regulating block when the tape having a narrow width is conveyed.

### Description of Embodiments

Embodiments of a tape feeder of the present disclosure will be described below. In the following drawings, the front-rear direction corresponds to the "path length direction" in the present disclosure, and the left-right direction corresponds to the "path width direction" in the present disclosure, respectively.

### <Configuration of Tape Feeder>

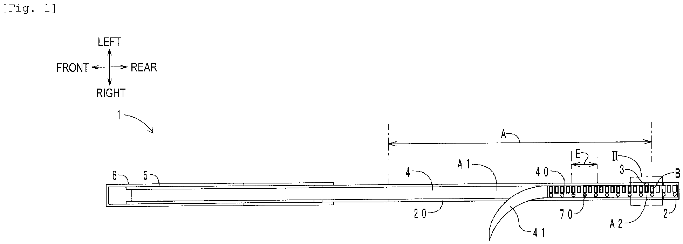

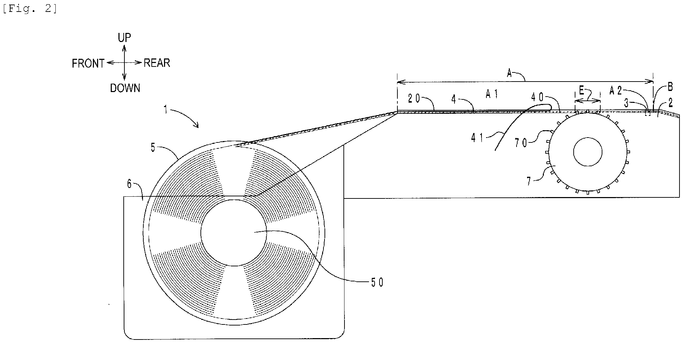

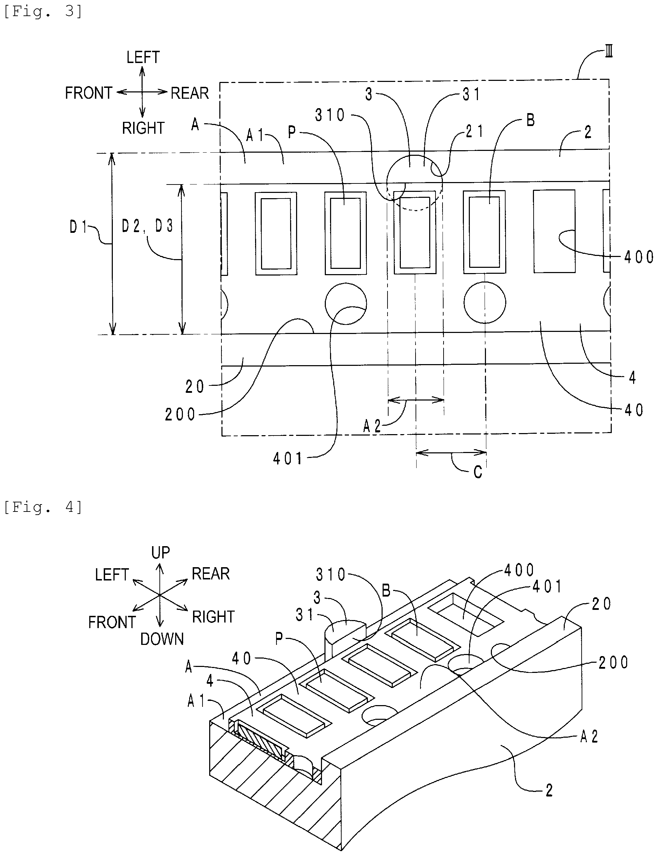

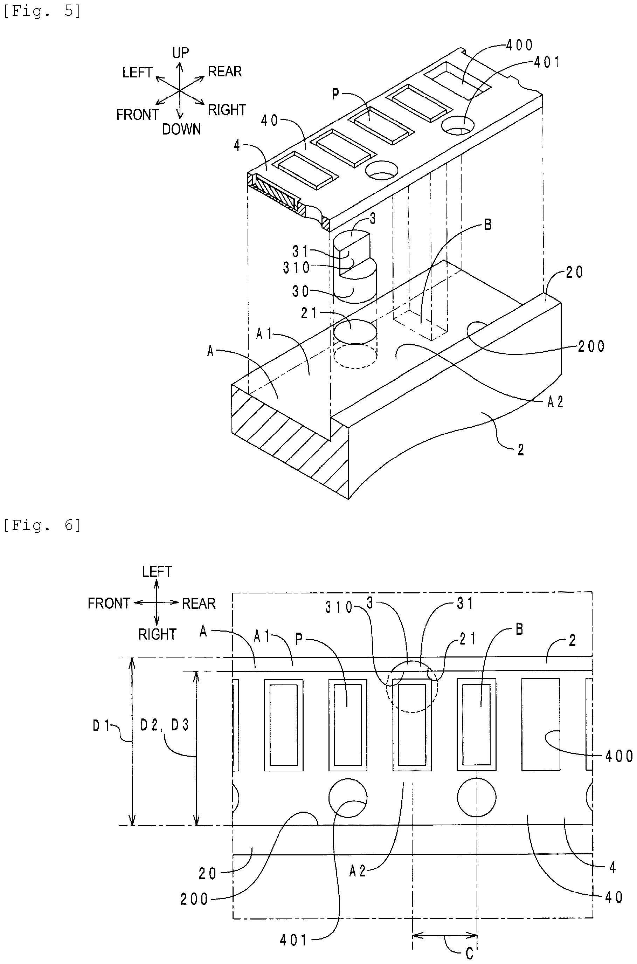

First, a configuration of the tape feeder of the present embodiment will be described. Fig. 1 illustrates a top view of the tape feeder of the present embodiment. Fig. 2 illustrates a transmission right view of the same tape feeder. Fig. 3 illustrates an enlarged view of a frame III of Fig. 1. Fig. 4 illustrates a perspective view of the frame III. Fig. 5 illustrates an exploded perspective view of the frame III.

Tape feeder 1 is exchangeably disposed in an electronic component mounting machine (not illustrated). Tape feeder 1 includes feeder main body 2, width regulating block 3, tape 4, reel 5, reel holder 6, and sprocket 7.

Feeder main body 2 has a narrow box shape that extends in the front-rear direction and the up-down direction. Feeder main body 2 includes conveyance path A, guide wall 20, and recessed portion 21. Conveyance path A, guide wall 20, recessed portion 21 are disposed on the upper face of feeder main body 2.

Guide wall 20 is disposed along the right edge of the upper face of feeder main body 2. Guide wall 20 extends in the front-rear direction. Left face (the inner face in the path width direction) of guide wall 20 is guide section 200. Guide section 200 has a planar shape that extends in the front-rear direction and the up-down direction.

Recessed portion 21 is recessed in the vicinity of the left edge of the upper face of feeder main body 2. Width regulating block 3 includes base section 30 and regulating section 31. Base section 30 has a cylindrical shape. Base section 30 is accommodated in recessed portion 21. Regulating section 31 is continuously formed on the upper side of base section 30. Regulating section 31 has a semicylindrical shape. Regulating section 31 protrudes from the upper face of feeder main body 2. Regulating section 31 includes abutting section 310. Abutting section 310 has a planar shape that extends in the front-rear direction and the up-down direction.

Conveyance path A extends in the front-rear direction. In the vicinity of the tail end (the end on the electronic component mounting machine side) of conveyance path A, extraction position B is set. At extraction position B, electronic component P is extracted from component accommodation section 400 of tape 4 to be described later by a suction nozzle (not illustrated) of the electronic component mounting machine. The electronic component P that has been extracted is mounted with a predetermined mounting coordinate on the board (not illustrated). Recessed portion 21 is disposed in front of the extraction position B. Recessed portion 21 and extraction position B are arranged adjacent to each other in the front-rear direction. Specifically, as illustrated in Fig. 3, recessed portion 21 and extraction position B are distanced from each other by interval C which is the distance between a pair of component accommodation sections 400 (specifically, the center of component accommodation section 400 in the front-rear direction) adjacent to each other in the front-rear direction.

Conveyance path A includes base width section A1 and narrow width section A2. Narrow width section A2 is disposed between width regulating block 3 on the left side and guide wall 20 on the right side. The left edge of narrow width section A2 is defined by abutting section 310. The right edge of narrow width section A2 is defined by guide section 200. Base width section A1 is set at a part other than narrow width section A2 in conveyance path A. The left edge of base width section A1 is defined by the left edge of the upper face of feeder main body 2. The right edge of base width section A1 is defined by guide section 200. Assuming that the width of base width section A1 in the left-right direction is D1, the width of narrow width section A2 in the left-right direction is D2, and the width of tape 4 in the left-right direction is D3, a relationship of D1 > D2 = D3 is established.

Sprocket 7 is accommodated inside feeder main body 2. Sprocket 7 is intermittently rotatable by a motor (not illustrated). Multiple teeth 70 are arranged at the outer peripheral edge of sprocket 7. Reel holder 6 is disposed on the rear side of feeder main body 2. Reel 5 is accommodated in reel holder 6, while being capable of being extracted.

Tape 4 is wound around shaft section 50 of reel 5. Tape 4 is pulled out from the upper portion of reel 5 to the rear side. Tape 4 which has been pulled out extends in the front-rear direction along conveyance path A. Tape 4 includes carrier tape 40 and cover tape 41.

Carrier tape 40 includes multiple component accommodation sections 400 and multiple feed holes 401. Multiple component accommodation sections 400 are each recessed on the upper face of carrier tape 40. Multiple component accommodation sections 400 are distanced from each other at predetermined intervals, and are arranged side by side in the front-rear direction (the longitudinal direction of carrier tape 40). In multiple component accommodation sections 400, respectively, electronic components P are accommodated. Multiple feed holes 401 each pass through carrier tape 40 in the up-down direction. Multiple feed holes 401 are distanced from each other at predetermined intervals, and are arranged side by side in the front-rear direction. Multiple feed holes 401 are arranged on the right side (one side of carrier tape 40 in the short direction) of multiple component accommodation sections 400.

Cover tape 41 is laminated on the upper side (outer side in the radial direction in a state of being wound around reel 5) of carrier tape 40. Cover tape 41 seals multiple component accommodation sections 400 from the upper side.

### <Effects>

Next, the effects of the tape feeder of the present embodiment will be described. Tape 4 is conveyed by sprocket 7. When sprocket 7 rotates, teeth 70 project from the upper face of feeder main body 2. Projecting teeth 70 mesh with feed holes 401 of tape 4. Subsequently, teeth 70 rotate from the front side toward the rear side. At this time, teeth 70 conveys feed hole 401, that is, tape 4, from the front side toward the rear side. In this manner, tape 4 is conveyed through conveyance path A. Here, conveyance path A has base width section A1 and narrow width section A2. Left-right direction width D1 of base width section A1 is wider than left-right direction width D3 of tape 4. Therefore, in base width section A1, tape 4 can be smoothly conveyed.

Left-right direction width D2 of narrow width section A2 is narrower than left-right direction width D1 of base width section A1. Therefore, in narrow width section A2, the deviation (for example, meandering, curvature or the like) of tape 4 in the left-right direction can be suppressed. Suppressing the deviation of tape 4 in the left-right direction makes it possible to suppress the deviation of the actual position of electronic component P with respect to extraction position B in the left-right direction. Therefore, the deviation of the suction position of the suction nozzle with respect to electronic component P in the left-right direction can be suppressed. Specifically, the deviation in the left-right direction between the center of gravity of the to-be-suctioned surface of electronic component P and the center of gravity of the nozzle tip of the suction nozzle can be suppressed. Accordingly, it is possible to improve the positional accuracy of electronic component P on the board.

Further, in narrow width section A2, the left edge of carrier tape 40 is in sliding contact with abutting section 310 of width regulating block 3. In a case where abutting section 310 is made of an elastic body (for example, rubber sponge or the like) (it is needless to say that an aspect in which abutting section 310 is made of an elastic body is also included in the present disclosure), there is a case where abutting section 310 is worn by sliding contact with carrier tape 40. In this regard, width regulating block 3, that is, abutting section 310 is made of a rigid body (for example, metal, resin or the like). Therefore, by sliding contact with carrier tape 40, abutting section 310 is unlikely to wear. Therefore, the deviation of tape 4 in the left-right direction can be suppressed for a long period of time.

Further, width regulating block 3 can be attachable to and detachable from recessed portion 21 of feeder main body 2. Therefore, the "tape deviation suppressing function" can be added to the existing tape feeder only by additionally disposing width regulating block 3 in the tape feeder. Further, by exchanging width regulating block 3 for each predetermined operation time (or every predetermined tape conveying distance), it is possible to suppress the deterioration (decrease in the tape deviation suppressing function) of abutting section 310 due to wear.

Further, width regulating block 3 is disposed in the vicinity of extraction position B. The position of width regulating block 3 with respect to extraction position B is within an interval between two times C in the down-stream direction of the extraction position and four times C in the up-stream direction of the extraction position B. Therefore, it is possible to suppress the deviation of tape 4 in the left-right direction at extraction position B.

Further, another case may be considered such that tape feed section (a section in which teeth 70 of sprocket 7 are inserted into feed holes 401) E illustrated in Fig. 2 and width regulating block 3 are arranged at the same position in the front-rear direction, in other words, tape feed section E and narrow width section A2 are arranged side by side in the left-right direction, are assumed (it is needless to say that an aspect in which tape feed section E and narrow width section A2 are arranged side by side in the left-right direction is also included in the present disclosure). In this case, when teeth 70 of sprocket 7 enter feed holes 401, tape 4 is unlikely to be shifted in the left-right direction. Therefore, teeth 70 of sprocket 7 are unlikely to enter feed holes 401. In this regard, according to tape feeder 1 of the present embodiment, tape feed section E and width regulating block 3 are disposed to be deviated in the front-rear direction. Therefore, when teeth 70 of sprocket 7 enter feed holes 401, tape 4 is likely to be shifted in the left-right direction in accordance with the insertion position of teeth 70. Therefore, teeth 70 of sprocket 7 are likely to enter feed holes 401.

### <Others>

Embodiments of the tape feeder of the present disclosure have been described above. However, the embodiments are not particularly limited to the above-described aspects. It is also possible to implement the present invention in various modifications as long as the modifications fall within the scope of the attached claims.

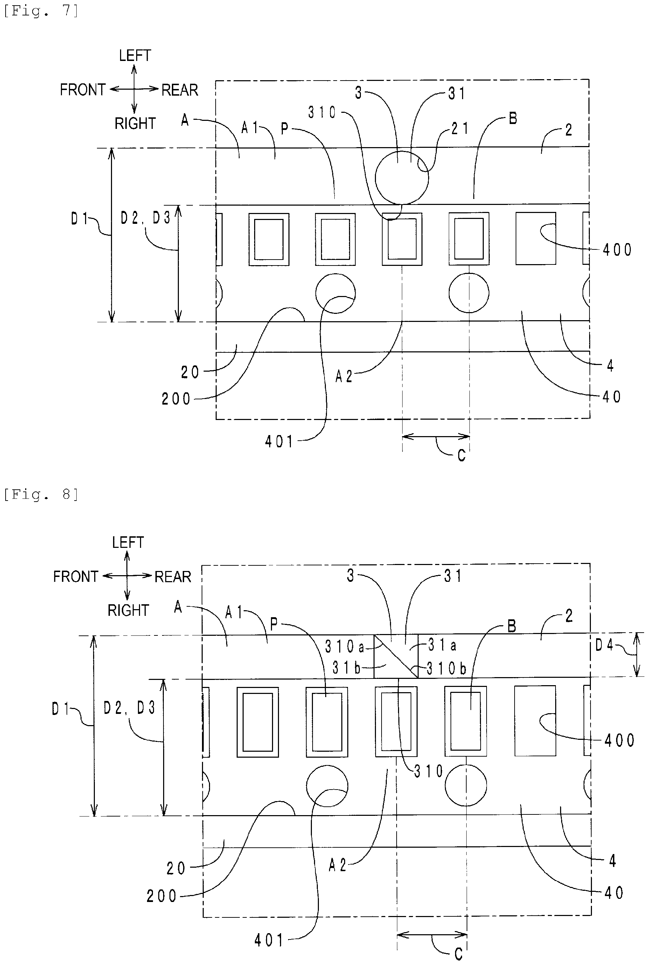

Fig. 6 illustrates a top view of the vicinity of the width regulating block of the tape feeder according to another (first) embodiment. Fig. 7 illustrates a top view of the vicinity of the width regulating block of the tape feeder according to another (second) embodiment. Portions corresponding to those in Fig. 3 will be given the same reference numerals.

As illustrated in Fig. 6, in a case where tape 4 having left-right direction width D3 wider than that in Fig. 3 is conveyed, width regulating block 3 in which abutting section 310 is disposed to be offset leftward (offset outward in the path width direction) may be used. As illustrated in Fig. 7, in a case where tape 4 having left-right direction width D3 narrower than that in Fig. 3 is conveyed, width regulating block 3 in which abutting section 310 is disposed to be offset rightward (offset inward in the path width direction) may be used. Abutting section 310 is in line contact with tape 4.

In this manner, in a case where tape feeder 1 is shared between multiple types of tapes 4 having widths different from each other, multiple width regulating blocks 3 in accordance with left-right direction width D3 of each tape 4 may be prepared. In this case, by exchanging width regulating block 3 in accordance with the type of tape 4, regardless of left-right direction width D3 of tape 4, the deviation of tape 4 in the left-right direction can be suppressed.

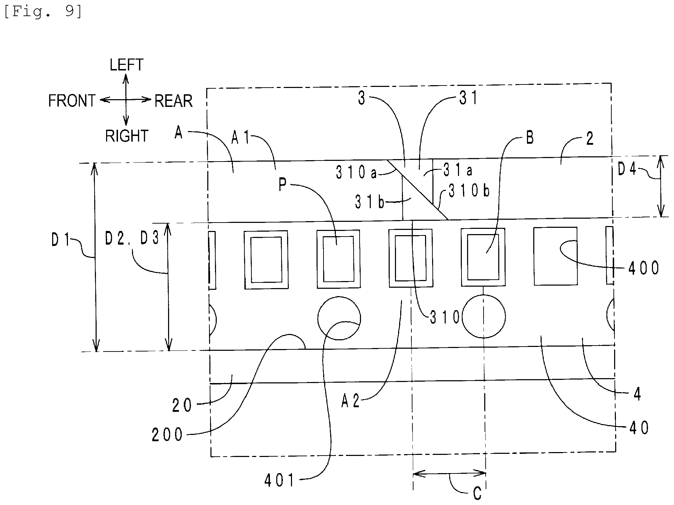

Fig. 8 illustrates a top view of the tape feeder according to another (third) embodiment, in the vicinity of the width regulating block when the tape having a wide width is conveyed. Fig. 9 illustrates a top view of the tape feeder in the vicinity of the width regulating block when the tape having a narrow width is conveyed. Portions corresponding to those in Fig. 3 will be given the same reference numerals.

As illustrated in Figs. 8 and 9, regulating section 31 includes first member 31a and second member 31b. First member 31a is continuous with base section 30 (refer to Fig. 5). First member 31a has guide surface 310a that extends in the oblique direction (a direction intersecting with the front-rear direction and the left-right direction). Second member 31b includes guided surface 310b that extends in the oblique direction, and abutting section 310. Guided surface 310b, that is, second member 31b are slidable with respect to guide surface 310a, that is, first member 31a, in the oblique direction.

As illustrated in Fig. 8, in a case where tape 4 having left-right direction width D3 wider than that of being illustrated in Fig. 9 is conveyed, guided surface 310b may be slide in the left-front direction (one side in the oblique direction) along guide surface 310a in a way such that left-right direction width D4 of regulating section 31 becomes narrow. As illustrated in Fig. 9, in a case where tape 4 having left-right direction width D3 narrower than that in Fig. 8 is conveyed, the guided surface 310b may be slid in the right-rear direction (the other side in the oblique direction) along guide surface 310a such that left-right direction width D4 of regulating section 31 becomes wide.

In this manner, in a case of sharing tape feeder 1 between multiple types of tapes 4 having widths different from each other, width regulating block 3 that can change left-right direction width D4 (the position in the left-right direction of abutting section 310) of regulating section 31 may be prepared. In this case, width regulating block 3 can be shared between multiple types of tapes 4 having widths different from each other.

Further, in a case of sharing tape feeder 1 between multiple types of tapes 4 having widths different from each other, guide wall 20 may be disposed only on one side in the left-right direction of the upper face of feeder main body 2. In this case, as compared with a case of arranging guide walls 20 on both sides in the left-right direction of the upper face of feeder main body 2, tape 4 having a wide width is likely to be conveyed. Further, left-right direction width D2 of narrow width section A2 may be wider than left-right direction width D3 of tape 4. In other words, a relationship of D1 > D2 > D3 may be established. Further, left-right direction width D2 of narrow width section A2 may be equal to or less than left-right direction width D3 of tape 4. In other words, a relationship of D1 > D3 ≥ D2 may be established.

Abutting section 310 of width regulating block 3 may be made of an elastic body. For example, the abutting section may be made of rubber, sponge, or leaf spring. Abutting section 310 may be made of a low friction material. For example, the abutting section may be made of fluorine resin, polyamide, or polyacetal. Further, in width regulating block 3 made of a rigid body, an elastic body (a leaf spring or the like) or a low friction material (film) for abutting section 310, may be arranged in combination. Regulating section 31 may be rotatable around an axis in the up-down direction with respect to base section 30. In this case, regulating section 31 can be rotated in accordance with the movement of tape 4. Therefore, abutting section 310 is unlikely to wear. Therefore, the deviation of tape 4 in the left-right direction can be suppressed for a long period of time.

The shapes of base section 30 and regulating section 31 are not particularly limited. For example, a pillar shape (a columnar shape, a polygonal columnar shape (a triangular columnar shape, a quadrangular columnar shape), a pillar shape obtained by removing a part of these shapes (partially cylindrical shape or the like), a tubular shape (a cylindrical shape, a polygonal cylindrical shape (a triangular cylindrical shape, a quadrangular cylindrical shape), a tubular shape obtained by removing a part of these shape (partially cylindrical shape or the like) may be employed. As illustrated in Figs. 8 and 9, in a case where the regulating section 31 has a width varying function, a width varying mechanism of regulating section 31 is not particularly limited. For example, first member 31a and second member 31b are juxtaposed in the left-right direction, and the gap width between first member 31a and second member 31b is adjusted by a width adjusting member (a spacer or the like), and accordingly, left-right direction width D4 of regulating section 31 may be adjusted. Multiple width regulating blocks 3 may be arranged on single conveyance path A. Single width regulating block 3 may include multiple abutting sections 310. The shape of abutting section 310 is not particularly limited. A planar shape, a curved shape, or the like may be employed. Abutting section 310 may be in contact with tape 4 in at least one aspect among point contact, line contact, and surface contact.

The position (position of abutting section 310) of width regulating block 3 with respect to extraction position B is, as illustrated in Fig. 3, including extraction position B, within (interval C×2) on the front side and may be within (interval C×4) on the rear side from extraction position B. In other words, abutting section 310 extends over the entire length of the region illustrated in Fig. 3 in the front-rear direction. Preferably, including extraction position B, each position may be within (interval C×2) in the front-rear direction from the extraction position B. In this way, the deviation of tape 4 in the left-right direction at extraction position B can be suppressed. Attaching method of width regulating block 3 with respect to feeder main body 2 is not particularly limited. Width regulating block 3 may be attached to feeder main body 2 by a method such as concavo-convex fitting, screwing, magnetic suctioning, bonding or the like.

Instead of width regulating block 3, the width regulating section integrated with feeder main body 2 may be disposed. Further, feeder main body 2 may not include guide wall 20. Feeder main body 2 may include a pair of left and right guide walls 20. Guide wall 20 may be partially disposed with respect to the entire length of conveyance path A.

### Reference Signs List

1: tape feeder, 2: feeder main body, 3: width regulating block, 4: tape, 5: reel, 6: reel holder, 7: sprocket, 20: guide wall, 21: recessed portion, 30: base section, 31: regulating section, 31a: first member, 31b: second member, 40: carrier tape, 41: cover tape, 50: shaft section, 70: tooth, 200: guide section, 310: abutting section, 310a: guide surface, 310b: guided surface, 400: component accommodation section, 401: feed hole, A: conveyance path, A1: base width section, A2: narrow width section, B: extraction position, C: interval, E: tape feed section, P: electronic component

## Claims

1. A tape feeder (1) comprising:
a feeder main body (2) including a conveyance path (A) through which a tape (4) having electronic components (P) accommodated therein in multiple component accommodation sections (400) is conveyed, and the conveyance path (A) having a base width section (A1) wider than the tape (4) and a narrow width section (A2) narrower than the base width section (A1), the base width section (A1) being provided at another part of the conveyance path (A) than the narrow width section (A2); and
a width regulating section (3) that abuts against the tape (4) conveyed through the conveyance path (A) from a path width direction of the conveyance path (A) so as to set the narrow width section (A2) on the conveyance path (A),
wherein the conveyance path (A) has an extraction position (B) at which the electronic component (P) is extracted from the tape (4), and
the multiple component accommodation sections (400) are provided at an interval C in the conveyance direction,
**characterized in that**
the width regulating section (3) is disposed in the vicinity of the extraction position (B) within an interval between two times C in the down-stream direction of the extraction position (B) and four times C in the up-stream direction of the extraction position (B).

2. The tape feeder according to claim 1,
wherein the width regulating section (3) is a width regulating block (3) attachable to and detachable from the feeder main body (2).

## Patentansprüche

1. Bandzuführer (1), umfassend:
einen Zuführer-Hauptkörper (2), der einen Förderweg (A) aufweist, durch den ein Band (4) mit elektronischen Komponenten (P), die darin in mehreren Komponentenaufnahmeabschnitten (400) untergebracht sind, gefördert wird, und wobei der Förderweg (A) einen Basisbreiten-Abschnitt (A1), der breiter als das Band (4) ist, und einen Schmalbreiten-Abschnitt (A2), der schmaler ist als der Basisbreiten-Abschnitt (A1), enthält, wobei der Basisbreiten-Abschnitt (A1) an einem anderen Teil des Förderwegs (A) vorgesehen ist als der Schmalbreiten-Abschnitt (A2); und
einen Breitenregulierungsabschnitt (3), der gegen das durch den Förderweg (A) geförderte Band (4) aus einer Wegbreitenrichtung des Förderwegs (A) anstößt, um so den Schmalbreiten-Abschnitt (A2) auf dem Förderweg (A) einzustellen,
wobei der Förderweg (A) eine Entnahmeposition (B) aufweist, an der die elektronische Komponente (P) von dem Band (4) entnommen wird, und
die mehreren Komponentenaufnahmeabschnitte (400) in einem Intervall C in der Förderrichtung vorgesehen sind,
**dadurch gekennzeichnet, dass**
der Breitenregulierungsabschnitt (3) in der Nähe der Entnahmeposition (B) innerhalb eines Intervalls zwischen zwei Mal C in der stromabwärtigen Richtung der Entnahmeposition (B) und vier Mal C in der stromaufwärtigen Richtung der Entnahmeposition (B) angeordnet ist.

2. Bandzuführer (1) nach Anspruch 1,
wobei der Breitenregulierungsabschnitt (3) ein Breitenregulierungsblock (3) ist, der an dem Zuführer- Hauptkörper (2) anbringbar und von diesem abnehmbar ist.

## Revendications

1. Chargeur de bande (1) comprenant :
un corps principal de chargeur (2) comprenant un chemin de transport (A) à travers lequel une bande (4),dans laquelle sont reçus des composants électroniques (P) dans de multiples sections de réception de composants (400), est transportée, et le chemin de transport (A) ayant une section de largeur de base (A1) plus large que la bande (4) et une section de largeur étroite (A2) plus étroite que la section de largeur de base (A1), la section de largeur de base (A1) étant prévue au niveau d'une partie du chemin de transport (A) autre que celle de la section de largeur étroite (A2) ; et
une section de régulation de largeur (3) qui vient en butée contre la bande (4) transportée à travers le chemin de transport (A) à partir d'une direction de largeur de chemin du chemin de transport (A) de manière à placer la section de largeur étroite (A2) sur le chemin de transport (A),
dans lequel le chemin de transport (A) a une position d'extraction (B) dans laquelle le composant électronique (P) est extrait de la bande (4), et
les multiples sections de réception de composants (400) sont prévues à un intervalle C dans la direction de transport,
**caractérisé en ce que**
la section de régulation de largeur (3) est disposée à proximité de la position d'extraction (B) dans un intervalle compris entre deux fois C dans la direction aval de la position d'extraction (B) et quatre fois C dans la direction amont de la position d'extraction (B).

2. Chargeur de bande selon la revendication 1,
dans lequel la section de régulation de largeur (3) est un bloc de régulation de largeur (3) pouvant être attaché au corps principal de chargeur (2) et détaché de celui-ci.
